# EUROPEAN PATENT APPLICATION

(11) **EP 4 394 013 A1**
(43) Date of publication of application: **03.07.2024**
(21) Application number: 21954786.6
(22) Date of filing: 05.11.2021
(51) Int. Cl.: C09J 123/08, C09J 123/06, C09J 11/06, C09J 7/10, C09J 7/30, H01L 23/29

(54) **BRIDGING AGENT, COMPOSITION, MASTERBATCH, PACKAGING FILM AND ELECTRONIC COMPONENT**

(30) Priority: 26.08.2021 CN 202110991133
(71) Applicant: Hangzhou First Applied Material Co., Ltd., Hangzhou, Zhejiang 311300 (CN)
(72) Inventor: TANG, Guodong, Hangzhou, Zhejiang 311300 (CN); LI, Bogeng, Hangzhou, Zhejiang 311300 (CN); ZHOU, Guangda, Hangzhou, Zhejiang 311300 (CN); HOU, Hongbing, Hangzhou, Zhejiang 311300 (CN); MEI, Yunxiao, Hangzhou, Zhejiang 311300 (CN); WEI, Mengjuan, Hangzhou, Zhejiang 311300 (CN)
(74) Representative: Casalonga
(86) International application number: PCT/CN2021/129110
(87) International publication number: WO 2023/024267

(57) **Abstract**

The disclosure provides a bridging agent, a composition, a masterbatch, an encapsulating glue film and an electronic component. The bridging agent has a cyclic structure with the following general structural formula: R¹ₓR²_{y}[CH₃SiO]ₙ, wherein n is an even number and 4≤n≤10; R¹ and R² are both connected to Si atoms, and the R¹ is a group having a terminal double bond; the R² is a linear alkyl group or a branched alkyl group having 4 to 14 carbon atoms; x is an even number greater than 1 and less than the n, and x+y is equal to the n; R¹s are in pairwise alignment, R²s are in pairwise alignment, the R¹s in pairwise alignment are the same, the R²s in pairwise alignment are the same, the R¹s that are not in alignment are either the same or different, and the R²s that are not in alignment are either the same or different. The bridging agent of the present disclosure reduces the probability of migration in a polyolefin resin, thereby the creep resistance of the polyolefin resin is improved, and the service life of the electronic component is prolonged.

## Description

### Technical Field

The disclosure relates to the field of optoelectronic technologies, in particular to a bridging agent, a composition, a masterbatch, an encapsulating glue film and an electronic component.

### Background

Polyolefin materials such as an ethylene-octene copolymer catalytic-synthesized by a metallocene catalyst are widely used as encapsulating materials for efficient electronic components such as a double-sided passivated emitter and rear cell (PERC) module, an N-type battery module, and a double-glass module due to excellent insulation, water resistance, potential induced degradation (PID) resistance, and acid-free corrosion resistance. Specifically, the encapsulating materials may play a role in installing, fixing, sealing, and protecting chips, thereby the chips are isolated from the outside world, as to prevent impurities in the air from corroding the chips and causing a decrease in appliance performance. However, due to the relatively low heat resistance and tensile resistance of existing encapsulating materials, the electronic components are prone to failure under the energy of heat, light, radiation and the like during encapsulating. In addition, with the extension of the working time of the electronic components, the heat and deformation released by long-term operation of the electronic components may further cause deformation and deterioration of the encapsulating materials, and finally cause that the service life of the electronic components is shortened.

### Summary

A main purpose of the disclosure is to provide a bridging agent, a composition, a masterbatch, an encapsulating glue film and an electronic component, as to a problem in existing technologies that the service life of electronic components is shortened due to the relatively low heat resistance and tensile resistance of encapsulating materials.

In order to achieve the above purpose, according to an aspect of the disclosure, a bridging agent is provided, and the bridging agent has a cyclic structure with the following general structural formula: R¹ₓR²_{y}[CH₃SiO]ₙ, wherein n is an even number and 4≤n≤10; R¹ and R² are both connected to Si atoms, and the R¹ is a group having a terminal double bond; the R² is a linear alkyl group or a branched alkyl group having 4 to 14 carbon atoms; x is an even number greater than 1 and less than the n, and x+y is equal to the n; R¹s are in pairwise alignment, R²s are in pairwise alignment, the R¹s in pairwise alignment are the same, the R²s in pairwise alignment are the same, the R¹ with no alignment relationship being identical or different, and the R² with no alignment relationship being identical or different.

Further, the above R¹ is a C₂-C₁₀ group having a terminal double bond, and the R² is a C₄-C₁₄ linear alkyl group or a C₄-C₁₄ branched alkyl group.

Further, the above n is an even number and 4≤n≤8.

Further, the above R¹ is selected from any one of vinyl, methacryloxypropyl, or allyl.

Further, the above R² is a C₈-C₁₄ linear alkyl group or a C₈-C₁₄ branched alkyl group, and R² is selected from any one of octyl, nonyl, decyl, isooctyl, isononyl, or isodecyl.

According to another aspect of the disclosure, a composition is provided, and calculated in parts by weight, the composition includes: 100 parts by weight of a non-polar polyolefin resin and 0.1-3 parts by weight of a bridging agent, the bridging agent is the above bridging agent.

Further, the above non-polar polyolefin resin is selected from any one or more of low-density polyethylene and ethylene-α olefin copolymer, and the ethylene-α olefin copolymer is selected from any one or more of linear low-density polyethylene, ethylene-propylene copolymer, ethylene-butene copolymer, ethylene-pentene copolymer, ethylene-hexene copolymer, and ethylene-octene copolymer.

According to another aspect of the disclosure, a masterbatch is provided, the masterbatch includes a composition, and the composition is the above composition.

According to another aspect of the disclosure, an encapsulating glue film is provided, which is obtained by mixing and melt-extruding various ingredients in a composition, and the composition is the above composition.

According to another aspect of the disclosure, an electronic component is provided, the electronic component includes any one of a solar cell, a liquid crystal panel, a field emitting device, a plasma display device, and a touch screen, at least one surface of the electronic component is in contact with an encapsulating glue film, and the encapsulating glue film is the above encapsulating glue film.

Polyolefin resin materials usually require chemical crosslinking with the participation of the bridging agent, as to guarantee the heat resistance and tensile resistance of the encapsulating material. Technical schemes of the disclosure are applied, because the bridging agent is a cyclic silane compound with a similar center symmetric structure, its positive and negative charge centers are coincided on the one hand, so the bridging agent is a compound of non-polar molecules, and according to the principle of similarity compatibility, the compatibility between the bridging agent and the non-polar polyolefin resin is improved. On the other hand, the R² substituent of the long carbon chain substituent increases its physical entanglement with a molecular chain of the polyolefin resin, so that its compatibility with the polyolefin resin is further improved. Therefore, the migration problem of the bridging agent is greatly reduced by the above two aspects of factors. At the same time, the terminal double bond provided by the R¹ substituent in the bridging agent molecule serves as a chemical crosslinking point, which may be chemically bonded with the molecular chain of the polyolefin resin under the initiation effects caused by heat, light, radiation and the like, thereby a larger crosslinking structure is formed, the creep resistance of the polyolefin resin is improved, and furthermore, the service life of the electronic component is prolonged.

### Detailed Description of the Embodiments

It should be noted that in the case without conflicting, embodiments in the present disclosure and features in the embodiments may be combined with each other. The disclosure is described in detail below in combination with the embodiments.

As analyzed in the background, there is a problem in existing technologies that the service life of electronic components is shortened due to the relatively low heat resistance and tensile resistance of encapsulating materials, in order to solve this problem, the disclosure provides a bridging agent, a composition, a masterbatch, an encapsulating glue film and an electronic component.

In a typical implementation mode of the present disclosure, a bridging agent is provided, and the bridging agent has a cyclic structure with the following general structural formula: R¹ₓR²_{y}[CH₃SiO]ₙ, wherein n is an even number and 4≤n≤10; R¹ and R² are both connected to Si atoms, and the R¹ is a group having a terminal double bond; the R² is a linear alkyl group or a branched alkyl group having 4 to 14 carbon atoms; x is an even number greater than 1 and less than the n, and x+y is equal to the n; R¹s are in pairwise alignment, and R²s are in pairwise alignment.

Polyolefin resin materials usually require chemical crosslinking with the participation of the bridging agent, as to guarantee the heat resistance and tensile resistance of the encapsulating material. Technical schemes of the disclosure are applied, because the bridging agent is a cyclic silane compound with a similar center symmetric structure, its positive and negative charge centers are coincided on the one hand, so the bridging agent is a compound of non-polar molecules, and according to the principle of similarity compatibility, the compatibility between the bridging agent and the non-polar polyolefin resin is improved. On the other hand, the R² substituent of the long carbon chain substituent increases its physical entanglement with a molecular chain of the polyolefin resin, so that its compatibility with the polyolefin resin is further improved. Therefore, the migration problem of the bridging agent is greatly reduced by the above two aspects of factors. At the same time, the terminal double bond provided by the R¹ substituent in the bridging agent molecule serves as a chemical crosslinking point, which may be chemically bonded with the molecular chain of the polyolefin resin under the initiation effects caused by heat, light, radiation and the like, thereby a larger crosslinking structure is formed, the creep resistance of the polyolefin resin is improved, and furthermore, the service life of the electronic component is prolonged.

In an embodiment of the present disclosure, the R¹ is a C₂-C₁₀ group having a terminal double bond, and the R² is a C₄-C₁₄ linear alkyl group or a C₄-C₁₄ branched alkyl group.

Preferably, the R¹ is the C₂-C₁₀ group having the terminal double bond, which is more beneficial to improve the polymerization efficiency and effect of the bridging agent molecules and the polyolefin resin, and the C₄-C₁₄ linear alkyl group or the C₄-C₁₄ branched alkyl group is more beneficial to increase its physical entanglement degree with polyolefin resin molecular chains, so that its compatibility with the polyolefin resin is further improved.

In an embodiment of the present disclosure, the n is an even number and 4≤n≤8.

The n is the larger, the circular skeleton of the bridging agent molecules is the larger. In order to reduce the large skeleton of the bridging agent molecules as much as possible so that its compatibility in the polyolefin resin becomes poor, preferably 4≤n≤8, further, the n is preferably 4 or 6, and furthermore, the n is preferably 4.

In order to further improve the efficiency of polymerization between the bridging agent molecules and the polyolefin resin molecular chains, preferably the R¹ is selected from any one of vinyl, methacryloxypropyl, or allyl.

Preferably, the R² is a C₈-C₁₄ linear alkyl group or a C₈-C₁₄ branched alkyl group, and the R² is selected from any one of octyl, nonyl, decyl, isooctyl, isononyl, or isodecyl, it is more beneficial to improve the compatibility of the bridging agent with the polyolefin resin.

In another typical implementation mode of the present disclosure, a composition is provided, and calculated in parts by weight, the composition includes: 100 parts by weight of a non-polar polyolefin resin and 0.1-3 parts by weight of a bridging agent, the bridging agent is the aforementioned bridging agent.

Because the bridging agent is a cyclic silane compound with a similar center symmetric structure, its positive and negative charge centers are coincided on the one hand, so the bridging agent is a compound of non-polar molecules, and according to the principle of similarity compatibility, the compatibility between the bridging agent and the non-polar polyolefin resin is improved. On the other hand, the R² substituent of the long carbon chain substituent increases its physical entanglement with a molecular chain of the polyolefin resin, so that its compatibility with the polyolefin resin is further improved. Therefore, the migration problem of the bridging agent is greatly reduced by the above two aspects of factors. At the same time, the terminal double bond provided by the R¹ substituent in the bridging agent molecule serves as a chemical crosslinking point, which may be polymerized with the molecular chain of the polyolefin resin under the initiation effects caused by heat, light, radiation and the like, thereby a larger crosslinking structure is formed, the creep resistance of the polyolefin resin is improved, and furthermore, the service life of the electronic component may be prolonged by using the encapsulating material obtained from the above composition.

Certainly, those skilled in the art may also add additives such as a tackifier, an ultraviolet light stabilizer, an ultraviolet light absorber, an antioxidant, a colorant, and an inorganic filler to the above composition according to actual needs, and the above composition may also contain a compound that may be decomposed to generate a hydrogen withdrawing free radical, thereby the crosslinking effect between the bridging agent molecules and the polyolefin resin molecules is further improved, and it is not repeatedly described here.

In order to further improve a non-polar polyolefin resin having the better compatibility with the above bridging agent, preferably the above non-polar polyolefin resin is selected from any one or more of low-density polyethylene and ethylene-α olefin copolymer, and the ethylene-α olefin copolymer is selected from any one or more of linear low-density polyethylene, ethylene-propylene copolymer, ethylene-butene copolymer, ethylene-pentene copolymer, ethylene-hexene copolymer, and ethylene-octene copolymer.

In another typical implementation mode of the present disclosure, a masterbatch is provided, the masterbatch includes a composition, and the composition is the above composition.

The masterbatch obtained by using the above composition has more uniform and stable compositions, and it not only has the excellent performance, but also has the longer service life in subsequent use.

In another typical implementation mode of the present disclosure, an encapsulating glue film is provided, which is obtained by mixing and melt-extruding various ingredients in a composition, and the composition is the above composition.

The above encapsulating glue film may be a single-layer glue film or a multi-layer glue film. If it is the multi-layer glue film, at least one layer contains the composition provided by the disclosure.

The encapsulating glue film obtained by the above composition has the excellent encapsulating effect.

In another typical implementation mode of the present disclosure, an electronic component is provided, the electronic component includes any one of a solar cell, a liquid crystal panel, a field emitting device, a plasma display device, and a touch screen, at least one surface of the electronic component is in contact with an encapsulating glue film, and the encapsulating glue film is the above encapsulating glue film.

The above encapsulating glue film is used for fixing, encapsulating, and protecting the electronic component, it may reduce the impact of external factors on the electronic component as much as possible, thereby the service life of the electronic component is improved.

The beneficial effects of the present disclosure are described below in combination with specific embodiments and contrast Embodiments.

Preparation methods for the bridging agent involved in the embodiments and contrast Embodiments below may refer to synthesis steps of a bridging agent A:
0.1 mol of methyl vinyl dimethoxysilane and 0.1 mol of octyl methyl dimethoxysilane are poured into a 250 mL round-bottom flask, and then 0.2 mol of hydrochloric acid solution with pH of 5 is added. After being stirred and reacted in an oil bath pan at 50 °C for 5 hours, clear solution is obtained. After by-product methanol is removed by using a rotary evaporator, 5 g of an anhydrous magnesium sulfate is added, it is dried for 24 hours, and filtered to obtain clear liquid. Finally, it is separated and purified by a silica gel column bonded with carbon 18. The mobile phase is the methanol, and the last component flowing out is the bridging agent A.

A gas chromatography-mass spectrometry (GC-MS) is used for detection, and specific parameters are shown in Table 1.

**Table 1**

| GC parameter | Detailed description | - |
|---|---|---|
| Chromatographic column | Agilent 19091S-433 | - |
| | 30m×250µm×0.25µm | |
| Injection volume | 0.5µL | - |
| Injection port temperature | 240 °C | - |
| Flow velocity | 1mL/min | - |
| MSD 5975C | Electron bombardment | - |
| Columnar temperature | Heating rate | Retention time |
| 100 °C | 10 °C/min | - |
| 290 °C | - | 25min |

Bridging agent A: the peak position on GC-MS was 18.4 minutes, and the molecular weight was 516.29.

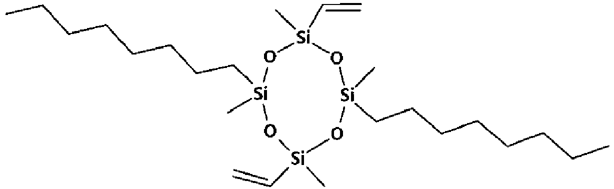

Bridging agent B: wherein R₃ was an octyl; and the peak position on GC-MS was 21.5 minutes, and the molecular weight was 688.33.

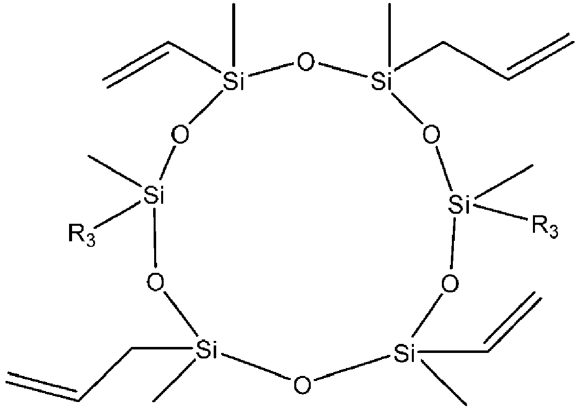

Bridging agent C: wherein R₄ was an octyl and R₅ was a decyl; and the peak position on GC-MS was 24.7 minutes, and the molecular weight was 1088.65.

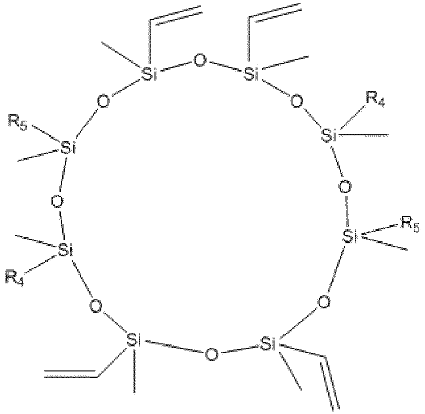

Bridging agent D: wherein R₆ and R₈ were an octyl, and R₇ was a decyl; and the peak position on GC-MS was 29.2 minutes, and the molecular weight was 1418.89.

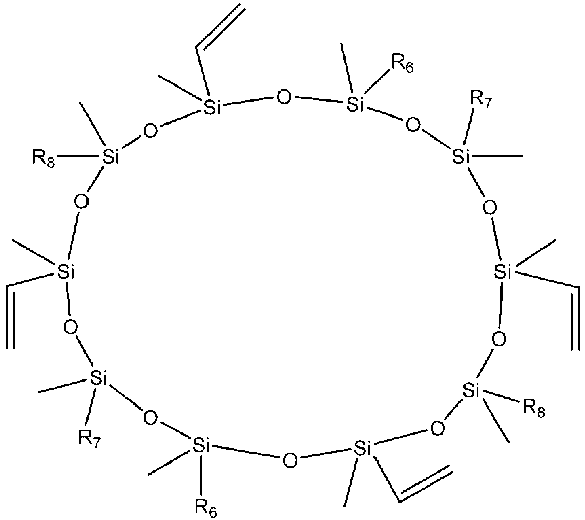

Bridging agent E:

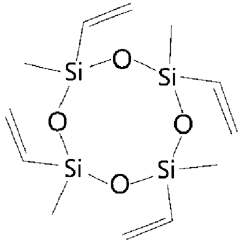

Bridging agent: triallyl isocyanurate (TAIC).

### Embodiment 1

100 parts by weight of an ethylene-octene copolymer (DOW Engage PV8669) and 1 part by weight of a bridging agent A, R¹₂R²₂[CH₃SiO]₄ (wherein R¹ was a vinyl and R² was an octyl), were taken, the two substances were mixed in a planetary mixer until the bridging agent was completely absorbed into ethylene-octene copolymer particles, and the surface of the particles was dry. The dried particles were plasticized and extruded by using a single-screw extruder with a length-to-diameter ratio of 32:1 and a screw diameter of 150 mm, and the temperature of a screw sleeve was 60-90 °C. Then, a T-shaped die was used for film-forming and casting. After being extruded by an embossing roller and a rubber roller, a specific texture structure was formed on the surface. Then, it was cooled to a room temperature by a cooling roller before being rolled up, to obtain an encapsulating glue film with a thickness of 0.6 mm.

### Embodiment 2

The difference between Embodiment 2 and Embodiment 1 was that:
R¹ was methacryloxypropyl, and an encapsulating glue film with a thickness of 0.6 mm was obtained finally.

### Embodiment 3

The difference between Embodiment 3 and Embodiment 1 was that:
R¹ was an allyl, and an encapsulating glue film with a thickness of 0.6 mm was obtained finally.

### Embodiment 4

The difference between Embodiment 4 and Embodiment 1 was that:
R² was a decyl, and an encapsulating glue film with a thickness of 0.6 mm was obtained finally.

### Embodiment 5

The difference between Embodiment 5 and Embodiment 1 was that:
R² was a butyl, and an encapsulating glue film with a thickness of 0.6 mm was obtained finally.

### Embodiment 6

The difference between Embodiment 6 and Embodiment 1 was that:
There were 3 parts by weight of a bridging agent A, and an encapsulating glue film with a thickness of 0.6 mm was obtained finally.

### Embodiment 7

The difference between Embodiment 7 and Embodiment 1 was that:
There were 0.1 parts by weight of a bridging agent A, and an encapsulating glue film with a thickness of 0.6 mm was obtained finally.

### Embodiment 8

The difference between Embodiment 8 and Embodiment 1 was that:
The ethylene-octene copolymer was replaced with low-density polyethylene, and an encapsulating glue film with a thickness of 0.6 mm was obtained finally.

### Embodiment 9

The difference between Embodiment 9 and Embodiment 1 was that:
The ethylene-octene copolymer was replaced with an ethylene-butene copolymer, and an encapsulating glue film with a thickness of 0.6 mm was obtained finally.

### Embodiment 10

The difference between Embodiment 10 and Embodiment 1 was that:
The bridging agent was a bridging agent B, and an encapsulating glue film with a thickness of 0.6 mm was obtained finally.

### Embodiment 11

The difference between Embodiment 11 and Embodiment 1 was that:
The bridging agent was a bridging agent C, and an encapsulating glue film with a thickness of 0.6 mm was obtained finally.

### Embodiment 12

The difference between Embodiment 12 and Embodiment 1 was that:
The bridging agent was a bridging agent D, and an encapsulating glue film with a thickness of 0.6 mm was obtained finally.

### Embodiment 13

100 parts by weight of an ethylene-octene copolymer (DOW Engage PV8669), 1 part by weight of a bridging agent A, R¹₂R²₂[CH₃SiO]₄ (wherein R¹ was a vinyl and R² was an octyl), and 0.5 parts by weight of tert-butylperoxy 2-ethylhexyl carbonate (TBEC) were taken, the three substances were mixed in a planetary mixer until the bridging agent was completely absorbed into ethylene-octene copolymer particles, and the surface of the particles was dry. The dried particles were plasticized and extruded by using a single-screw extruder with a length-to-diameter ratio of 32:1 and a screw diameter of 150 mm, and the temperature of a screw sleeve was 60-90 °C. Then, a T-shaped die was used for film-forming and casting. After being extruded by an embossing roller and a rubber roller, a specific texture structure was formed on the surface. Then, it was cooled to a room temperature by a cooling roller before being rolled up, to obtain an encapsulating glue film with a thickness of 0.6 mm.

### Embodiment 14

100 parts by weight of an ethylene-octene copolymer (DOW Engage PV8669), 1 part by weight of a bridging agent A, R¹₂R²₂[CH₃SiO]₄ (wherein R¹ was a vinyl and R² was an octyl), and 0.5 parts by weight of benzophenone were taken, the three substances were mixed in a planetary mixer until the bridging agent was completely absorbed into ethylene-octene copolymer particles, and the surface of the particles was dry. The dried particles were plasticized and extruded by using a single-screw extruder with a length-to-diameter ratio of 32:1 and a screw diameter of 150 mm, and the temperature of a screw sleeve was 60-90 °C. Then, a T-shaped die was used for film-forming and casting. After being extruded by an embossing roller and a rubber roller, a specific texture structure was formed on the surface. Then, it was cooled to a room temperature by a cooling roller before being rolled up, to obtain an encapsulating glue film with a thickness of 0.6 mm.

### Contrast Embodiment 1

The difference between Contrast Embodiment 1 and Embodiment 1 was that:
There were 0.01 parts by weight of a bridging agent A, and an encapsulating glue film with a thickness of 0.6 mm was obtained finally.

### Contrast Embodiment 2

The difference between Contrast Embodiment 2 and Embodiment 1 was that:
There were 4 parts by weight of a bridging agent A, and an encapsulating glue film with a thickness of 0.6 mm was obtained finally.

### Contrast Embodiment 3

The difference between Contrast Embodiment 3 and Embodiment 1 was that:
The bridging agent was TAIC, and an encapsulating glue film with a thickness of 0.6 mm was obtained finally.

### Contrast Embodiment 4

The difference between Contrast Embodiment 4 and Embodiment 1 was that:
The bridging agent was a bridging agent E, and an encapsulating glue film with a thickness of 0.6 mm was obtained finally.

### (1) Crosslinking degree and tensile strength test:

The encapsulating glue films obtained in Embodiments 1 to 12 and Contrast Embodiments 1 to 4 were irradiated respectively by using a high-energy electron beam, and the irradiation dose was 40 KGy. The encapsulating glue film in Embodiment 13 was laminated with a 150 °C laminator for 18 minutes. The encapsulating glue film in Embodiment 14 was irradiated with an ultraviolet lamp with a central wavelength of 365 nm, and the irradiation dose was 5000 mJ/cm². 1 g of the encapsulating glue film irradiated by the electron beam or the encapsulating glue film laminated by the high temperature or the encapsulating glue film irradiated by the ultraviolet light was weighed respectively by weight, boiling xylene was used for 5 hours of Soxhlet extraction, it was filtered with a 30-mesh stainless steel filter screen, and placed in a vacuum drying oven at 145 °C for 3 hours of drying under a reduced pressure. Finally, the weight of a residue on the screen was calculated as A(g), and the crosslinking degree was calculated by using the following formula. Crosslinking degree (weight%)=A×100%.

The laminator was used to eliminate surface textures on the encapsulating glue film irradiated, and then a standard mold was used to obtain a dumbbell-shaped standard sample strip with a thickness of 0.6 mm by stamping. The tensile strength of the encapsulating glue film was tested according to the ASTM D638-8 standard, and the unit was MPa.

### (2) Additive absorption capacity

The bridging agents A to E and TAIC were respectively prepared into 50 mL of 70% (mass fraction) methanol solution for standby. 1 g of the ethylene-octene copolymer particles (DOW Engage PV 8669) were weighed and placed in a stainless steel cage. Then, the stainless steel cage was immersed in the aforementioned methanol solution, and the particles were completely immersed in the solution. The entire immersing process lasted for 4 hours, and the ambient temperature was maintained at 25 °C. After being immersed, the polymer particles were taken out, surface liquid was wipe-dried with a paper towel, and it was weighed, to obtain a value B(g), it was the additive absorption capacity=(B-1)×100%.

The above tensile strengths of the encapsulating glue films obtained in Embodiments 1 to 14 and Contrast Embodiments 1 to 4 were listed in Table 2.

**Table 2**

| Embodiment/Contrast Embodiment | Crosslinking degree/% | Tensile strength/MPa |
|---|---|---|
| Embodiment 1 | 65.8 | 12.4 |
| Embodiment 2 | 67.1 | 13.0 |
| Embodiment 3 | 64.2 | 12.1 |
| Embodiment 4 | 64.0 | 12.0 |
| Embodiment 5 | 60.8 | 11.2 |
| Embodiment 6 | 58.3 | 10.9 |
| Embodiment 7 | 34.5 | 9.2 |
| Embodiment 8 | 61.9 | 13.7 |
| Embodiment 9 | 62.1 | 11.8 |
| Embodiment 10 | 61.8 | 11.0 |
| Embodiment 11 | 59.2 | 10.7 |
| Embodiment 12 | 55.7 | 9.6 |
| Embodiment 13 | 77.8 | 15.0 |
| Embodiment 14 | 69.3 | 13.6 |
| Contrast Embodiment 1 | 3.5 | 5.1 |
| Contrast Embodiment 2 | 12.9 | 6.2 |
| Contrast Embodiment 3 | 20.4 | 7.0 |
| Contrast Embodiment 4 | 25.7 | 7.8 |

The additive absorption capacities of the bridging agents A to E and TAIC were listed in Table 3.

**Table 3**

| Bridging agent | Additive absorption capacity/% |
|---|---|
| Bridging agent A | 9.1 |
| Bridging agent B | 8.0 |
| Bridging agent C | 7.2 |
| Bridging agent D | 6.3 |
| Bridging agent E | 3.2 |
| TAIC | 1.1 |

It was indicated from data in Table 3 above that the compatibility of the bridging agent in the present disclosure with the polyolefin resin was significantly better than that of the bridging agent E and TAIC in the existing technologies with the polyolefin resin.

From the above descriptions, it may be seen that the above embodiments of the disclosure achieve the following technical effects.

Polyolefin resin materials usually require chemical crosslinking with the participation of the bridging agent, as to guarantee the heat resistance and tensile resistance of the encapsulating material. Because the bridging agent of the disclosure is a cyclic silane compound with a similar center symmetric structure, its positive and negative charge centers are coincided on the one hand, so the bridging agent is a compound of non-polar molecules, and according to the principle of similarity compatibility, the compatibility between the bridging agent and the non-polar polyolefin resin is improved. On the other hand, the R² substituent of the long carbon chain substituent increases its physical entanglement with a molecular chain of the polyolefin resin, so that its compatibility with the polyolefin resin is further improved. Therefore, the migration problem of the bridging agent is greatly reduced by the above two aspects of factors. At the same time, the terminal double bond provided by the R¹ substituent in the bridging agent molecule serves as a chemical crosslinking point, which may be chemically bonded with the molecular chain of the polyolefin resin under the initiation effects caused by heat, light, radiation and the like, thereby a larger crosslinking structure is formed, the creep resistance of the polyolefin resin is improved, and furthermore, the service life of the electronic component is prolonged.

The above are only preferred embodiments of the disclosure, and are not intended to limit the disclosure. For those skilled in the art, the disclosure may have various modifications and changes. Any modifications, equivalent replacements, improvements and the like made within the spirit and principles of the disclosure shall be included within the scope of protection of the disclosure.

## Claims

1. A bridging agent, wherein the bridging agent has a cyclic structure with the following general structural formula: R¹ₓR²_{y}[CH₃SiO]ₙ, wherein n is an even number and 4≤n≤10; R¹ and R² are both connected to Si atoms, and the R¹ is a group having a terminal double bond; the R² is a linear alkyl group or a branched alkyl group having 4 to 14 carbon atoms; x is an even number greater than 1 and less than the n, and x+y is equal to the n; R¹s are in pairwise alignment, R²s are in pairwise alignment, the R¹s in pairwise alignment are the same, the R²s in pairwise alignment are the same, the R¹ with no alignment relationship being identical or different, and the R² with no alignment relationship being identical or different.

2. The bridging agent according to claim 1, wherein the R¹ is a C₂-C₁₀ group having a terminal double bond, and the R² is a C₄-C₁₄ linear alkyl group or a C₄-C₁₄ branched alkyl group.

3. The bridging agent according to claim 1, wherein the n is an even number and 4≤n≤8.

4. The bridging agent according to claim 1, wherein the R¹ is selected from any one of vinyl, methacryloxypropyl, or allyl.

5. The bridging agent according to any one of claims 1 to 4, wherein the R² is a C₈-C₁₄ linear alkyl group or a C₈-C₁₄ branched alkyl group, and the R² is selected from any one of octyl, nonyl, decyl, isooctyl, isononyl, or isodecyl.

6. A composition, wherein calculated in parts by weight, the composition comprises: 100 parts by weight of a non-polar polyolefin resin and 0.1-3 parts by weight of a bridging agent, and the bridging agent is the bridging agent according to any one of claims 1 to 5.

7. The composition according to claim 6, wherein the non-polar polyolefin resin is selected from any one or more of low-density polyethylene and ethylene-α olefin copolymer, and the ethylene-α olefin copolymer is selected from any one or more of linear low-density polyethylene, ethylene-propylene copolymer, ethylene-butene copolymer, ethylene-pentene copolymer, ethylene-hexene copolymer, and ethylene-octene copolymer.

8. A masterbatch, comprising a composition, wherein the composition is the composition according to claim 6 or 7.

9. An encapsulating glue film, obtained by mixing and melt-extruding various ingredients in a composition, wherein the composition is the composition according to claim 6 or 7.

10. An electronic component, wherein the electronic component comprises any one of a solar cell, a liquid crystal panel, a field emitting device, a plasma display device, and a touch screen, at least one surface of the electronic component is in contact with an encapsulating glue film, and the encapsulating glue film is the encapsulating glue film according to claim 9.
